# EUROPÄISCHE PATENTSCHRIFT

(11) **EP 3 014 960 B1**
(45) Veröffentlichungstag und Bekanntmachung des Hinweises auf die Patenterteilung: **09.08.2017**
(21) Anmeldenummer: 14727830.3
(22) Anmeldetag: 04.06.2014
(51) Int. Cl.: H05K 1/18, H05K 7/14

(54) **LEITERPLATTE MIT EINEM SCHWINGUNGSENTKOPPELTEN ELEKTRONISCHEN BAUELEMENT**
PRINTED CIRCUIT BOARD HAVING AN OSCILLATION-DECOUPLED ELECTRONIC COMPONENT
CIRCUIT IMPRIMÉ ÉQUIPÉ D'UN COMPOSANT ÉLECTRONIQUE DÉCOUPLÉ DES VIBRATIONS

(30) Priorität: 25.06.2013 DE 102013212053
(43) Veröffentlichungstag der Anmeldung: 04.05.2016
(73) Patentinhaber: Robert Bosch GmbH, 70442 Stuttgart (DE)
(72) Erfinder: SPRAUL, Manfred, 70469 Stuttgart (DE); DRESSLER, Marc, 70176 Stuttgart (DE)
(86) Internationale Anmeldenummer: PCT/EP2014/061537
(87) Internationale Veröffentlichungsnummer: WO 2014/206694

(56) Entgegenhaltungen:
- DE-A1-102005 021 726
- DE-A1-102006 015 676
- DE-A1-102008 035 420
- JP-A- H01 111 398
- US-A- 6 115 261
- US-A1- 2009 308 157

## Beschreibung

### Stand der Technik

Die Erfindung betrifft eine schwingfähige Substruktur für eine Anordnung mit einer Leiterplatte und mit einem schwingungsentkoppelten elektronischen Bauelement.

Bei aus dem Stand der Technik bekannten Leiterplatten mit einem elektronischen Bauelement, insbesondere einem Sensor, beispielsweise einem Beschleunigungssensor, besteht das Problem, dass auf die Leiterplatte übertragene mechanische Störschwingungen nicht zu dem elektronischen Bauelement, insbesondere dem Sensor, gelangen sollen, soweit der Sensor diese Störschwingungen als Störsignal empfangen kann, welches ein von dem Sensor zu erfassendes Nutzsignal überlagern und somit die Auswertung des Nutzsignals stören kann.

Aus dem Stand der Technik sind zur Lösung des Problems Feder- und/oder Dämpfungselemente bekannt, welche in Form eines Gels, eines Elastomers oder eines elastomeren Schaumes zwischen dem Bauelement und der Leiterplatte angeordnet sind.

Aus der DE 10 2006 015 676 A1 ist ein elektronisches Bauteil mit einem Trägerelement bekannt, das eine erste Montageebene aufweist, mit welcher das Trägerelement auf einer Leiterplatte mechanisch und/oder elektrisch kontaktiert werden kann, wobei das Trägerelement eine zweite Montageebene aufweist, auf der zumindest ein Beschleunigungssensor mit einer Sensierungsebene angeordnet ist, wobei die Sensierungsebene und die zweite Montageebene parallel zueinander gelegen sind, wobei die erste und die zweite Montageebene schief zueinander angeordnet sind.

DE 10 2005 021 726 A1 das als nächstliegender Stand der Technik angesehen wird beschreibt ein System zur Vibrationsschutz eines Sensors. Der Sensor ist durch ein Stützbein mit einer Leiterplatte mechanisch und elektrisch verbunden. Sowohl das Stützbein als auch die Leiterplatte ist unter Verwendung MID-Technologie hergestellt.

### Offenbarung der Erfindung

Erfindungsgemäß weist die Anordnung der eingangs genannten Art eine schwingfähig ausgebildete Substruktur nach Anspruch 1 auf. Die Substruktur ist mit der Leiterplatte auf einem Oberflächenbereich der Leiterplatte verbunden. Die Substruktur weist wenigstens einen Aufnahmeteller für das Bauelement auf. Die Substruktur ist ausgebildet, das Bauelement von einem von der Leiterplatte auf die Substruktur wirkenden Körperschall - bevorzugt für Frequenzen größer als 500 Hertz - zu entkoppeln. Bevorzugt ist der Aufnahmeteller mit dem Bauelement verbunden. Die Substruktur ist bevorzugt aus Kunststoff gebildet, wobei das Bauelement, insbesondere wenigstens ein elektrischer Anschluss des Bauelements, mittels wenigstens einer elektrischen Verbindungsleitung mit der Leiterplatte, insbesondere einem elektrischen Anschluss der Leiterplatte, verbunden ist. Die Substruktur ist bevorzugt als insbesondere räumliche Molded-Interconnect-Device-Struktur ausgebildet, welche die wenigstens eine elektrische Verbindungsleitung aufweist. Die Verbindungsleitung ist bevorzugt als elektrisch leitfähige Schicht, insbesondere Oberflächenschicht ausgebildet, welche mit der Substruktur, insbesondre einer Oberfläche der Substruktur, verbunden ist. Weiter bevorzugt ist die wenigstens eine elektrische Verbindungsleitung auf die Substruktur mittels Galvanisieren, thermischen Spritzen, insbesondere Plasmaspritzen, oder Kaltgasspritzen aufgebracht. Zum Galvanisieren kann die Substruktur beispielsweise mittels eines Lasers Oberflächenstrukturiert sein, so dass die elektrisch leitfähige Schicht in einem an die Oberflächenstrukturierung anschließenden Schritt mittels Galvanisieren erzeugt werden kann.

Zum thermischen Spritzen kann die Oberfläche der Substruktur im Bereich der zu erzeugenden elektrisch leitfähigen Schicht aufgeraut werden, um so eine Keimbildung für ein Schichtwachstum dort zu erzeugen. Das Aufrauen kann beispielsweise mittels eines Lasers als Positivstrukturierung durchgeführt werden.

Der elektrische Anschluss der Leiterplatte ist bevorzugt durch ein Lötpad, insbesondere Leiterbahnabschnitt gebildet.

Die schwingfähig, insbesondere federnd, ausgebildete Substruktur kann so vorteilhaft sowohl eine das elektronische Bauelement von der Leiterplatte entkoppelnde Feder oder zusätzlich einen Dämpfer bilden und mit seiner Eigenschaft als MID-Substruktur das elektronische Bauelement mit der Leiterplatte elektrisch verbinden. So kann vorteilhaft eine gesondert ausgebildete, insbesondere flexible Verbindungsleitung, beispielsweise eine Litze, welche sich von der Leiterplatte bis hin zu dem Bauelement erstreckt, vorteilhaft entfallen.

Bevorzugt ist die Substruktur durch einen Kunststoff, insbesondere Spritzguss erzeugten Kunststoff, gebildet. Der Kunststoff ist beispielsweise Polyethylen, Polypropylen, Polyamid, Poly-Butylen-Terephthalat, ABS (ABS = AcrylnitrilButadien-Styrol) oder LCP (LCP = Liquid-Chrystal-Polymer).

In einem bevorzugten Ausführungsbeispiel weist die Substruktur wenigstens ein quer zu einer ebenen Erstreckung der Leiterplatte, insbesondere einer Leiterplattenebene, erstreckendes Stützbein auf. Das Stützbein ist im Bereich eines Endes des Stützbeines mit der Leiterplatte verbunden. Das Stützbein ist weiter bevorzugt mindestens mittelbar mit dem Aufnahmeteller verbunden. Mittels des Stützbeins kann so vorteilhaft eine Torsionsfeder, oder eine nach Art eines Biegebalkens verformbar ausgebildete Feder, gebildet sein. Der Aufnahmeteller mit dem Bauelement ist so vorteilhaft von der Leiterplatte beabstandet, - bevorzugt parallel zur Leiterplatte beabstandet - angeordnet.

In einer bevorzugten Ausführungsform weist die Substruktur wenigstens einen Schwingarm auf. Der Schwingarm ist bevorzugt an das Stützbein angeformt und erstreckt sich weiter bevorzugt quer zum Stützbein. Der Schwingarm ist mindestens mittelbar mit dem Aufnahmeteller verbunden. Mittels des Schwingarmes kann so vorteilhaft eine Feder gebildet sein, mit der der Aufnahmeteller quer zu einer flachen Erstreckung der Leiterplatte mit der Leiterplatte federnd verbunden ist.

In einer bevorzugten Ausführungsform ist der Schwingarm mittels wenigstens eines Verbindungselements mit dem Aufnahmeteller verbunden. Das Verbindungselement verbindet einen Endabschnitt des Schwingarmes mit dem Aufnahmeteller. Mittels des Verbindungselements kann der Aufnahmeteller vorteilhaft beabstandet zu dem Schwingarm mit dem Schwingarm verbunden werden.

Bevorzugt weist die Substruktur wenigstens zwei Stützbeine auf. Die Stützbeine sind jeweils mit einem von der Leiterplatte abweisenden Endabschnitt mit zueinander gegenüberliegenden Endabschnitten eines Schwingarmes verbunden. Auf diese Weise kann der Schwingarm vorteilhaft im Bereich von zwei einander gegenüberliegenden Enden des Schwingarmes, jeweils durch ein Stützbein gestützt sein und mit einem Längsabschnitt, welcher sich zwischen den Stützbeinen erstreckt, quer zu seiner Längserstreckung schwingen.

Im Falle der Verbindung des Schwingarmes mit nur einem Ende an einem Stützbein, kann der Schwingarm mit dem vom Stützbein abweisenden Ende quer zu seiner Längserstreckung schwingen. Vorteilhaft kann sich über den Schwingarm sowohl im Falle der Stützung durch zwei Stützbeine oder im Falle der Stützung durch nur ein Stützbein eine Transversalwelle auf dem Schwingarm ausbreiten.

In einer bevorzugten Ausführungsform weist die Substruktur wenigstens zwei miteinander verbundene Schwingarme auf, welche sich jeweils parallel zur Leiterplattenebene erstrecken und welche einander überkreuzen. So kann vorteilhaft eine doppelte Feder gebildet sein, wobei zwei Einzelfedern der doppelten Feder, jeweils gebildet durch einen Schwingarm, so miteinander in Serie verbunden sind, sodass eine Federsteife der durch die Schwingarme gebildeten Gesamtfeder kleiner ist, als einer Einzelfeder, gebildet durch einen einzelnen Schwingarm.

In einer bevorzugten Ausführungsform der Substruktur ist einer der Schwingarme über wenigstens ein Stützbein mit der Leiterplatte verbunden und der andere Schwingarm über wenigstens ein Verbindungselement mit dem Aufnahmeteller verbunden. Weiter bevorzugt kann der eine Schwingarm zusammen mit zwei Stützbeinen eine U-Form bilden und der andere Schwingarm zusammen mit zwei Verbindungselementen, welche jeweils an zueinander gegenüberliegenden Enden des anderen Schwingarms an den Schwingarm angeformt sind, eine U-Form bilden. Weiter bevorzugt weisen die Öffnungen der so gebildeten U-Formen voneinander ab.

In einer bevorzugten Ausführungsform weist die Substruktur ein flach ausgebildetes Fußelement auf, welches mit der Leiterplatte verbunden, insbesondere klebeverbunden, steckverbunden oder lötverbunden ist. Bevorzugt ist das Fußelement mit wenigstens einem Stützbein der Substruktur verbunden, weiter bevorzugt an das wenigstens eine Stützbein angeformt. Auf diese Weise kann die Substruktur zum Verbinden mit der Leiterplatte einfach auf die Leiterplatte gestellt werden und mit der Leiterplatte verklebt und/oder verlötet werden. Bevorzugt ist die Substruktur mit der Leiterplatte lötverbunden, wobei ein Lötpad auf der Leiterplatte zum Verbinden mit der Substruktur ausgebildet ist, die Substruktur nach einem Verlöten zu halten. Dazu weist das Lötpad eine Flächenabmessung aufweist, welche einen hinreichend starken Stoffschluss mit der Substruktur erzeugt, so dass die Substruktur auch bei Erschütterungen der Leiterplatte fest mit der Leiterplatte verbunden bleiben kann. Das Lötpad ist bevorzugt mit der Verbindungsleitung der Substruktur elektrisch verbunden, so dass durch die Lötverbindung sowohl eine mechanische als auch elektrische Verbindung der Substruktur mit der Leiterplatte erzeugt ist.

In einer bevorzugten Ausführungsform weist die Substruktur wenigstens ein mäanderförmiges Federelement auf, welches den Aufnahmeteller mit der Leiterplatte mindestens mittelbar verbindet. Das mäanderförmige Federelement ist bevorzugt an den Aufnahmeteller und die Leiterplatte angeformt. Das mäanderförmige Federelement weist beispielsweise eine Halbwellenform oder eine Halbkreisform auf.

Mittels des mäanderförmigen Federelements kann die Substruktur vorteilhaft eckfrei ausgebildet sein.

In einer bevorzugten Ausführungsform weist die Substruktur wenigstens ein S-förmiges Federelement auf, wobei der Aufnahmeteller mit der Leiterplatte mindestens mittelbar über das S-förmige Federelement verbunden ist. Mittels des S-förmigen Federelements kann vorteilhaft ein eckfrei ausgebildetes Federelement gebildet sein. Weiter vorteilhaft kann das Federelement, insbesondere eine Federkonstante des Federelements, einfach berechnet werden.

Die Erfindung betrifft auch eine Substruktur gemäß der vorbeschriebenen Art. Die Substruktur ist ausgebildet, zwischen einem elektronischen Bauelement und einer Leiterplatte angeordnet zu werden, und weist einen Aufnahmeteller für das Bauelement auf und ist ausgebildet, das Bauelement von von der Leiterplatte auf die Substruktur wirkenden Körperschall zu entkoppeln. Die Substruktur ist als räumliche Molded-Interconnect-Device-Struktur ausgebildet, und weist wenigstens eine -- elektrische Verbindungsleitung auf, welche ausgebildet ist, einen elektrischen Anschluss des Bauelements mit einem Anschluss der Leiterplatte zu verbinden. Die elektrische Verbindungsleitung ist bevorzugt durch eine elektrisch leitfähige Schicht gebildet. Beispielsweise ist die Verbindungsleitung mittels Galvanisieren oder thermischen Spritzen auf einer Oberfläche der Substruktur erzeugt. Die Verbindungsleitung kann in einem anderen Ausführungsbeispiel mittels Lasersubtraktivstrukturierung einer galvanisch mit einer elektrisch leitfähigen Schicht beschichteten Substruktur erzeugt werden. In einer anderen Ausführungsform weist die Substruktur wenigstens zwei zueinander verschiedene Kunststoffe auf, wobei auf wenigstens einem Kunststoff die Verbindungsleitung ausgebildet ist. Der andere Kunststoff ist bevorzugt ausgebildet, beim Galvanisieren elektrisch leitfähiges, die elektrisch leitfähige Schicht bildendes Material abzuweisen. So kann nur auf dem Kunststoff, der das Material annimmt, die Verbindungsleitung ausgebildet sein.

Anders als die zuvor beschriebene Anordnung weist die Substruktur keine Leiterplatte und kein Bauelement auf.

Die Erfindung wird nun im Folgenden anhand von Figuren und weiteren Ausführungsbeispielen beschrieben. Weitere vorteilhafte Ausführungsvarianten ergeben sich aus den in den Figuren und den abhängigen Ansprüchen beschriebenen Merkmalen.
Figur 1 zeigt ein Ausführungsbeispiel für eine Anordnung mit einem elektronischen Bauelement und einer Substruktur, welche federnd oder zusätzlich dämpfend ausgebildet ist, und ausgebildet ist, mit einer Leiterplatte verbunden zu werden, wobei die Substruktur zwei Stützbeine und einen Schwingarm aufweist;
Figur 2 zeigt ein Ausführungsbeispiel für eine Anordnung mit einem elektronischen Bauelement und einer Substruktur, welche federnd oder zusätzlich dämpfend ausgebildet ist, und ausgebildet ist, mit einer Leiterplatte verbunden zu werden, wobei die Substruktur zwei Stützbeine und zwei einander überkreuzte Schwingarme aufweist;
Figur 3 zeigt ein Ausführungsbeispiel für eine Anordnung mit einem elektronischen Bauelement und einer Substruktur, welche federnd oder zusätzlich dämpfend ausgebildet ist, und ausgebildet ist, mit einer Leiterplatte verbunden zu werden und welche zwei Schwingarme aufweist, die jeweils mit einem Aufnahmeteller für ein elektronisches Bauelement verbunden sind;
Figur 4 zeigt ein Ausführungsbeispiel für eine Anordnung mit einem elektronischen Bauelement und einer Substruktur, welche federnd oder zusätzlich dämpfend ausgebildet ist und dazu ein S-förmiges Federelement aufweist;
Figur 5 zeigt ein Diagramm mit zwei Transferfunktionen zu der Substruktur gemäß Figur 2, welche quer zur Achse 12 angeregt wurde;
Figur 6 zeigt ein Diagramm mit zwei Transferfunktionen zu der Substruktur gemäß Figur 2, welche in Richtung der Achse 12 angeregt wurde.

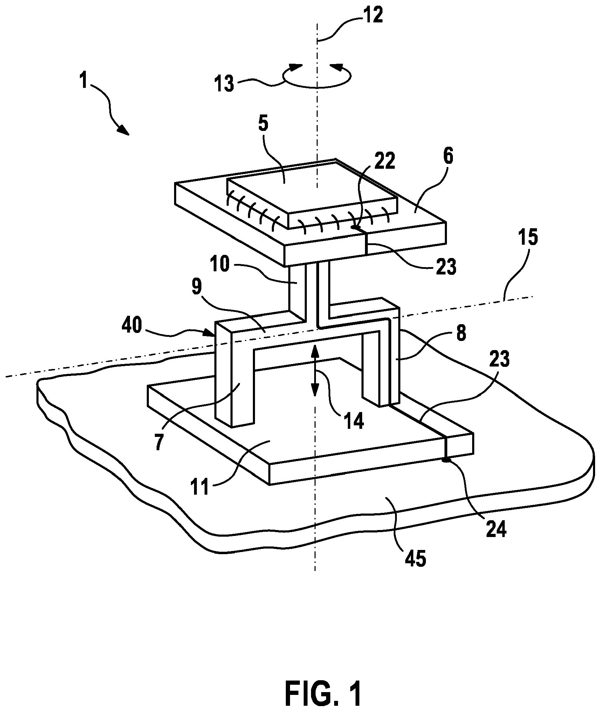

Figur 1 zeigt ein Ausführungsbeispiel für eine Anordnung 1. Die Anordnung 1 umfasst ein elektronisches Bauelement 5. Das elektronische Bauelement 5 ist beispielsweise ein Beschleunigungssensor, insbesondere ein MEMS-Sensor (MEMS = Micro-Electrical-Mechanical-System). Das Bauelement 5 ist mit einem Aufnahmeteller 6 einer federnd oder zusätzlich dämpfend ausgebildeten Substruktur 40 verbunden. Die Substruktur 40 weist auch ein Stützbein 7 und ein Stützbein 8 auf, wobei die Stützbeine 7 und 8 sich zueinander parallel und voneinander beabstandet erstrecken und jeweils mit einem Endabschnitt mit einem Fuß 11, insbesondere einer Fußplatte der Substruktur 40, verbunden, in diesem Ausführungsbeispiel an den Fuß 11 angeformt sind. Die von dem Fuß 11 abweisenden Endabschnitte der Stützbeine 7 und 8 sind jeweils mittels eines Schwingarmes 9 miteinander verbunden. Der Schwingarm 9 erstreckt sich mit wenigstens einer Querkomponente zur Längserstreckung der Stützbeine 7 und 8, in diesem Ausführungsbeispiel quer, also im rechten Winkel zur Längserstreckung der Stützbeine 7 und 8. An den Schwingarm 9 ist auf einem Längsabschnitt des Schwingarmes, welcher sich zwischen den Stützbeinen 7 und 8 erstreckt, ein Verbindungselement 10 angeordnet, welches an den Schwingarm 9 angeformt ist. Der Schwingarm 9 ist über das Verbindungselement 10 mit dem Aufnahmeteller 6 verbunden. Der Aufnahmeteller 6 erstreckt sich in diesem Ausführungsbeispiel mit seiner flachen Erstreckung parallel zu dem Fuß 11. Der Fuß 11 ist in diesem Ausführungsbeispiel mit einer Leiterplatte 45 verbunden, insbesondere verklebt.

Das elektronische Bauelement 5 weist elektrische Anschlüsse auf, von denen der elektrische Anschluss 22 beispielhaft bezeichnet ist. Der Anschluss 22 ist mittels einer elektrischen Verbindungsleitung 23 mit einem Anschluss 24 verbunden. Der Anschluss 24 ist beispielsweise durch einen Leiterbahnabschnitt einer Leiterbahn der Leiterplatte 45 gebildet. Die elektrischen Anschlüsse 22 und 24 können beispielweise sowohl die elektrische Verbindung als auch mechanische Fixierung der Substruktur mit der Leiterplatte erzeugen. Die elektrische Verbindungsleitung 23 ist in diesem Ausführungsbeispiel als sich längserstreckende Kupferschicht gebildet, welche mittels Galvanisieren, Laserstrukturieren oder thermischen Spritzen, insbesondere Plasmaspritzen, auf die Substruktur 40 aufgebracht ist. Die Substruktur 40 bildet so ein Molded-Interconnect-Device.

Das elektronische Bauelement 5 kann zusammen mit dem Aufnahmeteller 6 quer zu einer flachen Erstreckung des Aufnahmetellers 6, entlang einer Achse 12, schwingen und dabei eine Translationsbewegung, insbesondere eine Hin- und Herbewegung 14 entlang der Achse 12 ausführen. Der Aufnahmeteller 6, welcher zusammen mit dem elektronischen Bauelement 5 gemeinsam eine schwingende Masse bildet, schwingt dabei zusammen mit dem Verbindungselement 10 auf dem Schwingarm 9. Der Schwingarm 9 bildet so für die der zur vorbeschriebenen Schwingung entlang der Achse 12 entsprechenden Schwingungsmode eine Feder.

Die Substruktur 40 ist in diesem Ausführungsbeispiel ausgebildet, weitere Schwingungsmoden auszubilden. Beispielsweise kann das elektronische Bauelement 5 zusammen mit dem Aufnahmeteller 6, um die Längsachse 15 des Schwingarmes 9 eine Schwenkbewegung ausführen, wobei die Schwenkbewegung eine weitere Schwingungsmode repräsentiert.

Das elektronische Bauelement 5 kann zusammen mit dem Aufnahmeteller 6 auch um die Achse 12 eine Rotationsbewegung 13 ausführen. Die Rotationsbewegung 13 entspricht dabei einer weiteren Schwingungsmode der Substruktur 40.

Das elektronische Bauelement 5 kann so wirksam für Frequenzen größer als eine vorbestimmte Resonanzfrequenz der Substruktur 40 wirksam von der Leiterplatte 45 entkoppelt werden. Vorteilhaft bleibt das elektronische Bauelement 5 über die elektrischen Verbindungen, wie die Verbindungsleitung 23, mit der Leiterplatte 45 verbunden.

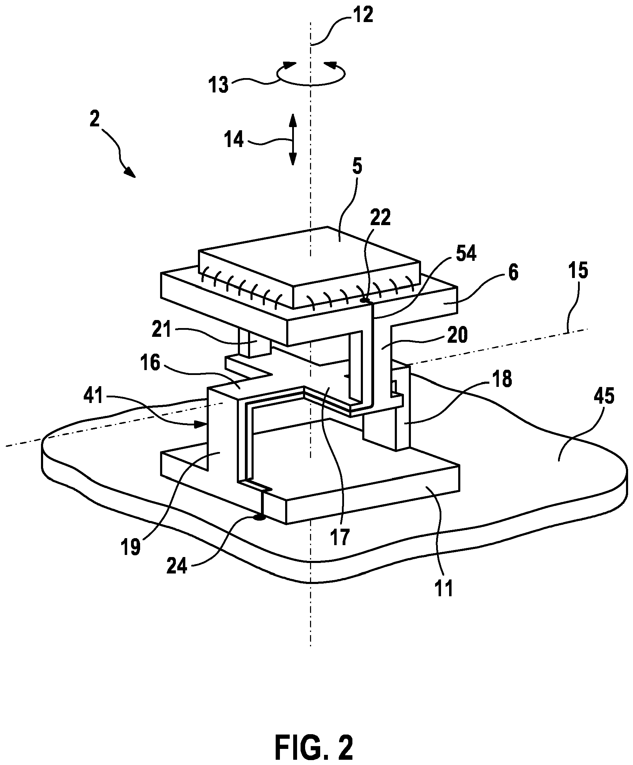

Figur 2 zeigt ein Ausführungsbeispiel für eine Anordnung 2. Die Anordnung 2 weist wie die Anordnung 1 in Figur 1 das elektronische Bauelement 5 auf, welches mit einem Aufnahmeteller 6 verbunden ist. Die Anordnung 2 weist auch eine Substruktur 41 auf, welche anders als die Substruktur 40 in Figur 1 ausgebildet ist. Die Substruktur 41 umfasst den Aufnahmeteller 6 und einen sich zum Aufnahmeteller 6 parallel beabstandet erstreckenden, flach ausgebildeten Fuß 11. Die Substruktur 41 weist auch zwei Stützbeine 18 und 19 auf, welche wie die Stützbeine 7 und 8 in Figur 1 zueinander beabstandet sind und an den Fuß 11 angeformt sind. Die Stützbeine 18 und 19 erstrecken sich mit wenigstens einer Querkomponente von dem Fuß 11 und weisen so von dem Fuß 11 ab. In diesem Ausführungsbeispiel erstrecken sich die Stützbeine 18 und 19 quer zu einer flachen Erstreckung des Fußes 11. Die Stützbeine 18 und 19 sind mittels eines Schwingarmes 16 miteinander verbunden. Die Substruktur 41 weist auch einen weiteren Schwingarm 17 auf, welcher an dem Schwingarm 16 auf einem Längsabschnitt des Schwingarmes 16 mit dem Schwingarm 16 verbunden ist und sich mit wenigstens einer Querkomponente, in diesem Ausführungsbeispiel quer zur Längserstreckung des Schwingarmes 16, erstreckt. Die Schwingarme 16 und 17 bilden somit ein Kreuz.

Die Substruktur 41 weist auch zwei Verbindungselemente 20 und 21 auf, wobei das Verbindungselement 20 im Bereich eines Endes des Schwingarms 17 mit dem Schwingarm 17 verbunden ist und das Verbindungselement 21 mit dem Schwingarm 17 im Bereich eines zu dem Verbindungselement 20 gegenüberliegenden Endes mit dem Schwingarm 17 verbunden ist. Die Verbindungselemente 20 und 21 verbinden den Aufnahmeteller 6 mit dem Schwingarm 17, sodass der Aufnahmeteller 6 von dem Schwingarm 17 beabstandet angeordnet ist. Die Verbindungselemente 20 und 21 bewirken so, dass der Schwingarm 17 im Bereich der zwei Enden des Schwingarms 17 mit dem Aufnahmeteller 6 verbunden ist. Sowohl der Schwingarm 17, als auch der Schwingarm 16 können so gemeinsam, oder je nach Schwingungsmode der Substruktur 41, als Feder wirken. Das elektronische Bauelement 5 kann so gemäß einer Translationsbewegung 14 entlang der Achse 12 schwingen, wobei die Achse 12 sich quer zu einer flachen Erstreckung des Aufnahmetellers 6 erstreckt. Das elektronische Bauelement 5 kann auch zusammen mit dem Aufnahmeteller 6 eine Rotationsbewegung 13 um die Achse 12 ausführen, oder eine Rotationsbewegung 13 um die Achse 15, welche in der Längserstreckung des Schwingarmes 16 verläuft. Das elektronische Bauelement 5 kann auch eine Rotationsbewegung um eine Längserstreckung des Schwingarmes 17 ausführen. Die Substruktur 41 ist so ausgebildet, das elektronische Bauelement 5 in drei rotatorischen und drei translatorischen Freiheitsgraden schwingend zu lagern. Die Substruktur 41 ist auch ausgebildet, das elektronische Bauelement 5 elektrisch mit einer Leiterplatte 45 zu verbinden. Die Substruktur 41 ist dazu mittels des Fußes 11 mit der Leiterplatte 45, beispielsweise mittels eines Klebstoffs oder einer Lötverbindung mit einem Lötpad der Leiterplatte verbunden.

Dargestellt ist auch ein elektrischer Anschluss 24 der Leiterplatte 45, welcher mittels einer elektrischen Verbindungsleitung 54 mit einem elektrischen Anschluss 22 des elektrischen Bauelements 5 verbunden ist. Die elektrische Verbindungsleitung 54 ist beispielsweise mittels Galvanisieren, Laserstrukturieren oder thermischen Spritzen, insbesondere Plasmaspritzen, auf die Substruktur 41 erzeugt.

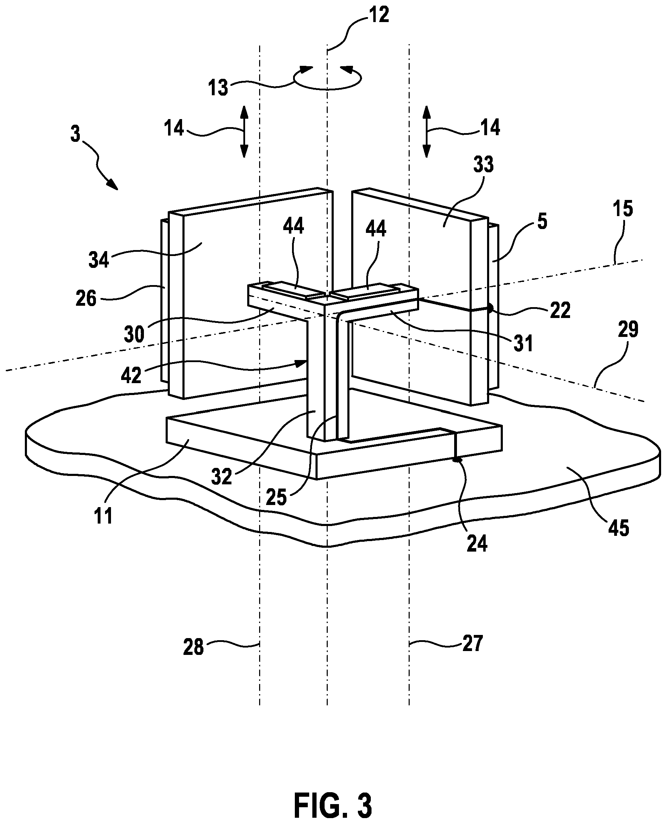

Figur 3 zeigt ein Ausführungsbeispiel für eine Anordnung 3, umfassend eine Substruktur 42, ein elektronisches Bauelement 5 und ein elektronisches Bauelement 26. Die Anordnung 3 kann weiter auch die abschnittsweise dargestellte Leiterplatte 45 umfassen. Die elektronischen Bauelemente 5 und 26 sind jeweils mittels der Substruktur 42 schwingungsentkoppelt mit der Leiterplatte 45 verbunden und mittels der Substruktur 42, insbesondere mittels einer elektrischen Verbindungsleitung 25, welche mit der Substruktur 42 verbunden ist, mit der Leiterplatte 45 und dort mit einem elektrischen Anschluss 24 verbunden.

Die Substruktur 42 weist - anders als die Substrukturen 40 und 41 - für jedes der Bauelemente 5 und 26 einen Aufnahmeteller 33 für das Bauelement 5 und einen Aufnahmeteller 34 für das Bauelement 26 auf. Die Aufnahmeteller 33 und 34 sind jeweils mit ihrer flachen Erstreckung quer zu einer flachen Erstreckung der Leiterplatte 45 und so zu einer flachen Erstreckung eines Fußes 11 der Substruktur 42 angeordnet. Dazu ist der Aufnahmeteller 33 mittels eines Schwingarmes 31 mit einem Stützbein 32 verbunden und der Aufnahmeteller 34 mittels eines Schwingarmes 30 mit dem Stützbein 32 verbunden.

Das Stützbein 32 ist - von den Schwingarmen 30 und 31 beabstandet - mit dem Fuß 11 verbunden und an den Fuß 11 angeformt.

Die Aufnahmeteller 33 und 34 weisen mit ihrer flachen Erstreckung jeweils in zueinander verschiedene Richtungen, in diesem Ausführungsbeispiel sind die Aufnahmeteller 33 und 34 orthogonal zueinander angeordnet.

Das elektronische Bauelement 5 ist beispielsweise als Beschleunigungssensor ausgebildet, wobei der Beschleunigungssensor Beschleunigungen in zwei zueinander verschiedenen räumlichen Richtungen erfassen kann. Das elektronische Bauelement 26 ist beispielsweise durch einen weiteren Beschleunigungssensor gebildet, welcher ausgebildet ist, eine Beschleunigung in einer Richtung, insbesondere quer zu einer flachen Erstreckung des elektronischen Bauelements 26 und so quer zu einer flachen Erstreckung des Aufnahmetellers 34 und entlang einer Achse 29 zu erfassen. Die Achse 29 verläuft entlang einer Längserstreckung des Schwingarmes 30.

Die Achsen 12, 15 und 29 bilden in diesem Ausführungsbeispiel gemeinsam ein Orthogonalsystem.

In einer anderen Ausführungsform sind die Schwingarme 31 und 30 nicht parallel zur Leiterplatte 45 angeordnet, sondern erstrecken sich jeweils mit einer Querkomponente zu einer flachen Erstreckung des Fußes 11, und so Leiterplattenebene der Leiterplatte 45. Die Schwingarme 30 und 31 bilden so gemeinsam eine V-Form, wobei eine durch die V-Form aufgespannt Ebene sich orthogonal zur Leiterplattenebene bzw. der Ebene des Fußes 11 erstreckt. Die Schwingarme 30 und 31 können zusammen mit den Aufnahmetellern 33 und 34 anstelle des Stützbeins 32 mit einer Struktur wie in Figur 1 dargestellt verbunden sein, so dass die Schwingarme 30 und 31 anstelle des Verbindungselements 10 in Figur 1 als stehende V-Form an den Schwingarm 9 angeformt sind.

Die Substruktur 42 weist in diesem Ausführungsbeispiel auch ein Dämpfungselement 44 auf. Das Dämpfungselement 44 ist mit wenigstens einem Schwingarm, in diesem Ausführungsbeispiel mit beiden Schwingarmen 31 und 30, verbunden. Das Dämpfungselement 44 ist in diesem Ausführungsbeispiel durch eine Dämpfungsschicht, insbesondere eine EDPM-Schicht, gebildet. Das Dämpfungselement 44 kann zusätzlich zur EPDM-Schicht eine weitere Schicht aufweisen, sodass das Dämpfungselement 44 als Sandwich-Element ausgebildet ist. Auf diese Weise kann das Dämpfungselement 44 mit einer kleinen Dickenerstreckung eine große Dämpfungswirkung erzielen. Im Falle eines einfachen Dämpfungselements beträgt eine beispielhafte Dickenerstreckung des Dämpfungselements 44 wenigstens das 1,5-Fache einer Dickenerstreckung des Schwingungsarmes 31 beziehungsweise des Schwingungsarmes 30.

So kann eine neutrale Biegefaser einer Schwingungsbewegung des Schwingungsarmes 30 beziehungsweise 31 in dem Dämpfungselement 44 liegen. Das Material des Dämpfungselements 44 wird so durch eine Scherbewegung um die neutrale Biegefaser herum bewegt und kann so seine Dämpfungswirkung zur Dämpfung der Schwingbewegung entfalten.

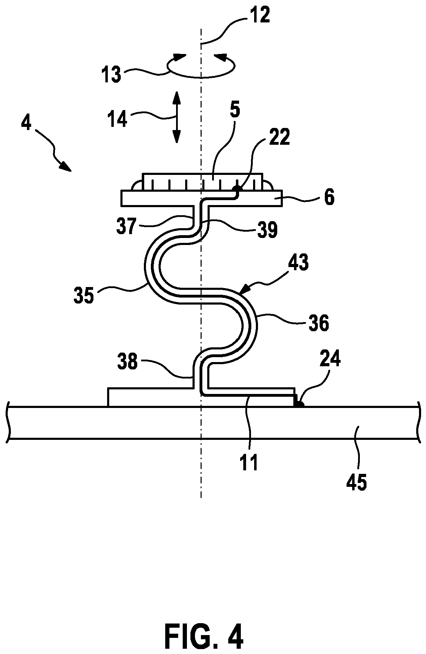

Figur 4 zeigt ein Ausführungsbeispiel für eine Substruktur 43 als Bestandteil einer Anordnung 4. Die Substruktur 43 weist zwei mäanderförmige Federelemente 35 und 36 auf, welche gemeinsam eine S-Form ausbilden. Das Federelement 35 ist über ein Verbindungselement 37 mit einem Aufnahmeteller 6 der Substruktur 43 verbunden. Der Aufnahmeteller 6 trägt ein elektronisches Bauelement 5, welches mit dem Aufnahmeteller 6 verbunden ist. Das Federelement 36 ist über ein Verbindungselement 38 mit einem Fuß 11 der Substruktur 43 verbunden.

Der Aufnahmeteller 6 ist in diesem Ausführungsbeispiel parallel zum Fuß 11 beabstandet angeordnet und schließt die Verbindungselemente 37 und 38 und die Federelemente 35 und 36 zwischeneinander ein.

Das elektronische Bauelement 5 kann so entlang einer Achse 12, welche sich quer zur flachen Erstreckung des Aufnahmetellers 6 erstreckt, entlang einer Translationsrichtung 14 schwingen, oder auch eine Rotationsbewegung 13 um die Achse 12 ausführen. Weitere Schwingungsmoden der Substruktur 43 können beispielsweise eine Schwenkbewegung des Aufnahmetellers 6 um einen Fußpunkt im Bereich des Fußes 11, insbesondere im Bereich des Verbindungselements 38, umfassen. So ist das elektronische Bauelement 5 vorteilhaft in drei translatorischen Freiheitsgraden und weiteren rotatorischen Freiheitsgraden von einer Leiterplatte 45, welche beispielsweise mit dem Fuß 11 verbunden ist, schwingungsentkoppelt.

Ein elektrischer Anschluss 22 des elektronischen Bauelements 5, welches beispielsweise ein Beschleunigungssensor ist, ist mittels einer mittels Galvanisieren, Laserstrukturieren oder mittels thermischen Spritzen auf die Substruktur 43 aufgebrachten elektrischen Verbindungsleitung 39 mit einem elektrischen Anschluss 24 der Leiterplatte 45 verbunden. Die elektrische Verbindungsleitung 39 verläuft von dem Anschluss 22, also dem elektronischen Bauelement 5, über den Aufnahmeteller 6, also über das Verbindungselement 37, weiter über die Federelemente 35 und 36 und über das Verbindungselement 38 und weiter über den Fuß 11 bis hin zum Anschluss 24.

Der Anschluss 24 ist mittels der Verbindungsleitung 39 beispielsweise mittels Löten, insbesondere Reflow-Löten, verbunden.

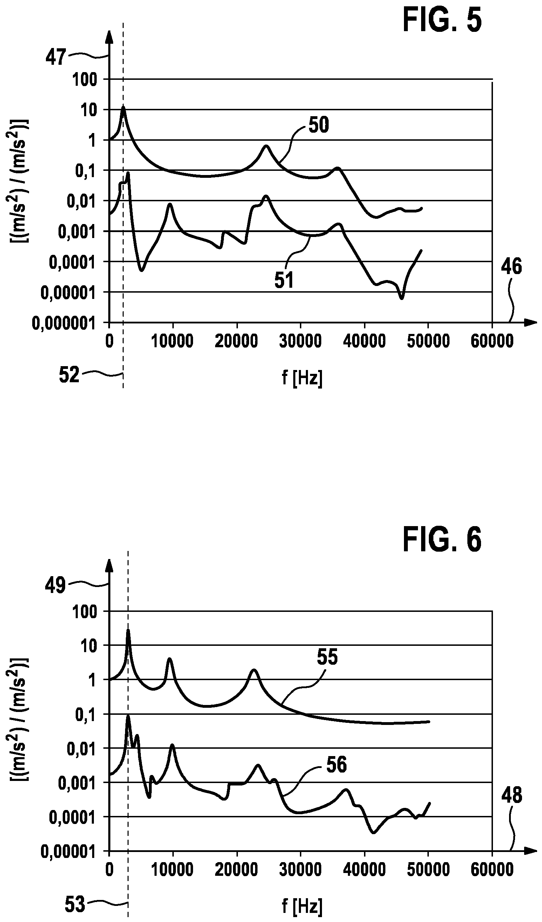

Figur 5 zeigt ein Diagramm mit zwei Transferfunktionen 50 und 51 zu der Substruktur 41 gemäß Figur 2, welche in Richtung der Achse 12 am Fuß 11 angeregt wurde. Dargestellt ist eine Frequenzachse 46 und eine Achse 47, welche die - dimensionslose - Transferfunktion repräsentiert. Sichtbar ist eine erste Resonanzfrequenz 52, wobei die Substruktur 41 für Frequenzen Anregefrequenzen größer als die Frequenz 52 eine Entkopplung von der Leiterplatte bewirkt. Die Transferfunktion 50 repräsentiert die Antwortschwingung der Substruktur 41 in Richtung der Achse 12, die Transferfunktion 51 repräsentiert die Antwortschwingung der Substruktur 41 quer zur Achse 12, jeweils bezogen auf eine Anregung in Richtung der Achse 12 am Fuß 11 der Substruktur 41.

Figur 6 zeigt ein Diagramm mit zwei Transferfunktionen 55 und 56 zu der Substruktur 41 gemäß Figur 2, welche quer zur Achse 12 am Fuß 11 angeregt wurde. Dargestellt ist eine Frequenzachse 48 und eine Achse 49, welche die - dimensionslose - Transferfunktion repräsentiert. Sichtbar ist eine erste Resonanzfrequenz 53, wobei die Substruktur 41 für Frequenzen Anregefrequenzen größer als die Frequenz 52 eine Entkopplung von der Leiterplatte bewirkt. Die Transferfunktion 55 repräsentiert die Antwortschwingung der Substruktur 41 in Richtung der Achse 12, die Transferfunktion 56 repräsentiert die Antwortschwingung der Substruktur 41 quer zur Achse 12, jeweils bezogen auf eine Anregung quer zur Achse 12 am Fuß 11 der Substruktur 41.
Ein Erfassungsfrequenzbereich des Sensors beträgt beispielsweise bis zu 500 Hertz. Die Resonanzfrequenz 52 oder 53 liegt beispielsweise zwischen 1000 Hertz und 10000 Hertz, so dass eine Entkopplung für Frequenzen größer als die Resonanzfrequenz wirksam ist. So kann Störschall größer als die Resonanzfrequenz wirksam vom Sensor entkoppelt werden.

## Patentansprüche

1. Schwingfähige Substruktur aus Kunststoff (40, 41, 42, 43) die ausgebildet ist, zwischen wenigstens einem elektronischen Bauelement (5, 25) und einer Leiterplatte (45) angeordnet zu werden, und welche einen Aufnahmeteller (6, 33, 34) für das Bauelement (5, 26) aufweist und ausgebildet ist, das Bauelement (5, 26) von von der Leiterplatte (45) auf die Substruktur (40, 41, 42, 43) wirkenden Körperschall zu entkoppeln, wobei die Substruktur (40, 41, 42, 43) als räumliche Molded-Interconnect-Device-Struktur ausgebildet ist, und wenigstens eine durch eine elektrisch leitfähige Schicht gebildete elektrische Verbindungsleitung aufweist, welche ausgebildet ist, einen elektrischen Anschluss (22) des Bauelements (5, 26) mit einem Anschluss (24) der Leiterplatte (45) zu verbinden, wobei die Substruktur (40, 41, 42, 43) wenigstens ein Stützbein (7, 8, 18, 19, 32) aufweist, welches ausgebildet ist im Bereich eines Endes des Stützbeins (7, 8, 18, 19, 32) mit der Leiterplatte (45) verbunden zu werden und mindestens mittelbar dem Aufnahmeteller (6, 33, 34) verbunden ist, **dadurch gekennzeichnet dass** mittels des Stützbeines (7, 8, 18, 19, 32) eine Torsionsfeder gebildet ist, so dass das Bauelement (5, 26) zusammen mit dem Aufnahmeteller (6, 33, 34) eine Rotationsbewegung (13) ausführen kann.

2. Anordnung (1, 2, 3, 4) mit einer Leiterplatte (45) und mit einem schwingungsentkoppelten elektronischen Bauelement (5, 26),
wobei die Anordnung (1, 2, 3, 4) eine schwingfähig ausgebildete Substruktur (40, 41, 42, 43) nach Anspruch 1 aufweist, welche mit der Leiterplatte (45) auf einem Oberflächenbereich der Leiterplatte (45) verbunden ist, und welche wenigstens einen Aufnahmeteller (6, 33, 34) für das Bauelement (5, 26) aufweist und ausgebildet ist, das Bauelement (5, 26) von von der Leiterplatte (45) auf die Substruktur (40, 41, 42, 43) wirkenden Körperschall zu entkoppeln, wobei der Aufnahmeteller (6) mit dem Bauelement (5, 26) verbunden ist, und die Substruktur (40, 41, 42, 43) aus Kunststoff gebildet ist, wobei das Bauelement, insbesondere wenigstens ein elektrischer Anschluss (22) des Bauelements (5, 26), mittels wenigstens einer durch eine elektrisch leitfähige Schicht gebildete elektrische Verbindungsleitung (23, 25, 39, 54) mit der Leiterplatte (45) verbunden ist, wobei die Substruktur (40, 41, 42, 43) als räumliche Molded-Interconnect-Device-Struktur ausgebildet ist, welche die wenigstens eine elektrische Verbindungsleitung (23, 25, 39, 54) aufweist, wobei
die Substruktur (40, 41, 42, 43) wenigstens ein quer zu einer ebenen Erstreckung der Leiterplatte (45), insbesondere Leiterplattenebene, erstreckendes Stützbein (7, 8, 18, 19, 32) aufweist, welches im Bereich eines Endes des Stützbeins (7, 8, 18, 19, 32) mit der Leiterplatte (45) verbunden und mindestens mittelbar dem Aufnahmeteller (6, 33, 34) verbunden ist, wobei mittels des Stützbeins 7, 8, 18, 19, 32) eine Torsionsfeder gebildet ist, so dass das Bauelement (5, 26) zusammen mit dem Aufnahmeteller (6, 33, 34) eine Rotationsbewegung (13) ausführen kann.

3. Anordnung (1, 2, 3, 4) nach Anspruch 2,
**dadurch gekennzeichnet, dass**
die Substruktur (40, 41, 42, 43) ausgebildet ist, das Bauelement (5, 26) von einem von der Leiterplatte (45) auf die Substruktur (40, 41, 42, 43) wirkenden Körperschall für Frequenzen größer als 500 Hertz zu entkoppeln.

4. Anordnung (1, 2, 3, 4) nach Anspruch 2 oder 3,
**dadurch gekennzeichnet, dass**
die Substruktur (40, 41, 42, 43) wenigstens einen Schwingarm (9, 16, 17, 30, 31) aufweist, welcher an das Stützbein angeformt ist und sich quer zum Stützbein (7, 8, 18, 19, 32) erstreckt und mindestens mittelbar mit dem Aufnahmeteller (6, 33, 34) verbunden ist.

5. Anordnung (1, 2, 3, 4) nach einem der vorhergehenden Ansprüche,
**dadurch gekennzeichnet, dass**
der Schwingarm (9, 16, 17, 30, 31) mittels eines Verbindungselements (10, 20, 21) mit dem Aufnahmeteller (6, 33, 34) verbunden ist, das einen Endabschnitt des Schwingarmes (9, 16, 17, 30, 31) mit dem Aufnahmeteller (6, 33, 34) verbindet.

6. Anordnung (1, 2, 3, 4) nach einem der vorhergehenden Ansprüche,
**dadurch gekennzeichnet, dass**
die Substruktur (40, 41, 42, 43) wenigstens zwei Stützbeine (7, 8, 18, 19, 32) aufweist, welche jeweils mit einem von der Leiterplatte (45) abweisenden Endabschnitt mit zueinander gegenüberliegenden Endabschnitten eines Schwingarmes (9, 16, 17, 30, 31) verbunden sind.

7. Anordnung (1, 2, 3, 4) nach einem der vorhergehenden Ansprüche,
**dadurch gekennzeichnet, dass**
die Substruktur (40, 41, 42, 43) wenigstens zwei miteinander verbundene Schwingarme (9, 16, 17, 30, 31) aufweist, welche sich jeweils parallel zur Leiterplattenebene erstrecken und welche einander überkreuzen.

8. Anordnung (1, 2, 3, 4) nach Anspruch 7,
**dadurch gekennzeichnet, dass**
einer der Schwingarme (9, 16, 17, 30, 31) über wenigstens ein Stützbein (7, 8, 18, 19, 32) mit der Leiterplatte (45) verbunden ist und der andere Schwingarm (9, 16, 17, 30, 31) über wenigstens ein Verbindungselement (10, 20, 21) mit dem Aufnahmeteller (6, 33, 34) verbunden ist.

9. Anordnung (1, 2, 3, 4) nach einem der vorhergehenden Ansprüche,
**dadurch gekennzeichnet, dass**
die Substruktur (40, 41, 42, 43) ein flach ausgebildetes Fußelement (11) aufweist, welches mit der Leiterplatte (45) verbunden, insbesondere klebeverbunden oder lötverbunden ist.

10. Anordnung (1, 2, 3, 4) nach einem der vorhergehenden Ansprüche,
**dadurch gekennzeichnet, dass**
die Substruktur (40, 41, 42, 43) wenigstens ein mäanderförmiges Federelement (35, 36) aufweist, wobei der Aufnahmeteller (6, 33, 34) mittels des Federelements (35, 36) mindestens mittelbar mit der Leiterplatte (45) verbunden ist.

11. Anordnung (1, 2, 3, 4) nach einem der vorhergehenden Ansprüche,
**dadurch gekennzeichnet, dass**
die Substruktur (40, 41, 42, 43) wenigstens ein S-förmiges Federelement (35, 36) aufweist, wobei der Aufnahmeteller (6, 33, 34) mit der Leiterplatte (45) mindestens mittelbar über das Federelement (35, 36) verbunden ist.

## Claims

1. Plastic substructure (40, 41, 42, 43) which is capable of oscillation and is designed to be arranged between at least one electronic component (5, 25) and a printed circuit board (45), and which has a receptacle plate (6, 33, 34) for the component (5, 26) and is designed to decouple the component (5, 26) from structural noise acting from the printed circuit board (45) on the substructure (40, 41, 42, 43), wherein the substructure (40, 41, 42, 43) is designed as a three-dimensional molded interconnect device structure, and has at least one electrical connecting line formed by an electrically conductive layer, which is designed to connect an electrical terminal (22) of the component (5, 26) to a terminal (24) of the printed circuit board (45), wherein the substructure (40, 41, 42, 43) has at least one support leg (7, 8, 18, 19, 32) which is designed to be connected in the region of one end of the support leg (7, 8, 18, 19, 32) to the printed circuit board (45) and which is at least indirectly connected to the receptacle plate (6, 33, 34), **characterized in that** a torsion spring is formed by means of the support leg (7, 8, 18, 19, 32) so that the component (5, 26) can execute a rotational movement (13) together with the receptacle plate (6, 33, 34).

2. Arrangement (1, 2, 3, 4) having a printed circuit board (45) and having an oscillation-decoupled electronic component (5, 26),
wherein
the arrangement (1, 2, 3, 4) has a substructure (40, 41, 42, 43) according to Claim 1, which is designed to be capable of oscillation, and which is connected to the printed circuit board (45) on a surface region of the printed circuit board (45), and which has at least one receptacle plate (6, 33, 34) for the component (5, 26) and is designed to decouple the component (5, 26) from structural noise acting from the printed circuit board (45) on the substructure (40, 41, 42, 43), wherein the receptacle plate (6) is connected to the component (5, 26), and the substructure (40, 41, 42, 43) is formed from plastic, wherein the component, in particular at least one electrical terminal (22) of the component (5, 26), is connected by means of at least one electrical connecting line (23, 25, 39, 54), which is formed by an electrically conductive layer, to the printed circuit board (45), wherein the substructure (40, 41, 42, 43) is designed as a three-dimensional molded interconnect device structure, which has the at least one electrical connecting line (23, 25, 39, 54), wherein the substructure (40, 41, 42, 43) has at least one support leg (7, 8, 18, 19, 32), which extends transversely to a planar extension of the printed circuit board (45), in particular the printed circuit board plane, and which is connected in the region of one end of the support leg (7, 8, 18, 19, 32) to the printed circuit board (45) and is at least indirectly connected to the receptacle plate (6, 33, 34), wherein a torsion spring is formed by means of the support leg (7, 8, 18, 19, 32) so that the component (5, 26) can execute a rotational movement (13) together with the receptacle plate (6, 33, 34).

3. Arrangement (1, 2, 3, 4) according to Claim 2,
**characterized in that**
the substructure (40, 41, 42, 43) is designed to decouple the component (5, 26) from a structural noise acting from the printed circuit board (45) on the substructure (40, 41, 42, 43) for frequencies greater than 500 Hz.

4. Arrangement (1, 2, 3, 4) according to Claim 2 or 3,
**characterized in that**
the substructure (40, 41, 42, 43) has at least one oscillation arm (9, 16, 17, 30, 31), which is formed onto the support leg and extends transversely to the support leg (7, 8, 18, 19, 32) and is at least indirectly connected to the receptacle plate (6, 33, 34).

5. Arrangement (1, 2, 3, 4) according to any one of the preceding claims,
**characterized in that**
the oscillation arm (9, 16, 17, 30, 31) is connected by means of a connecting element (10, 20, 21), which connects an end section of the oscillation arm (9, 16, 17, 30, 31) to the receptacle plate (6, 33, 34), to the receptacle plate (6, 33, 34).

6. Arrangement (1, 2, 3, 4) according to any one of the preceding claims,
**characterized in that**
the substructure (40, 41, 42, 43) has at least two support legs (7, 8, 18, 19, 32), which are each connected with an end section facing away from the printed circuit board (45) to opposing end sections of an oscillation arm (9, 16, 17, 30, 31).

7. Arrangement (1, 2, 3, 4) according to any one of the preceding claims,
**characterized in that**
the substructure (40, 41, 42, 43) has at least two oscillation arms (9, 16, 17, 30, 31), which are connected to one another, and which each extend in parallel to the printed circuit board plane and which cross over one another.

8. Arrangement (1, 2, 3, 4) according to Claim 7,
**characterized in that**
one of the oscillation arms (9, 16, 17, 30, 31) is connected via at least one support leg (7, 8, 18, 19, 32) to the printed circuit board (45) and the other oscillation arm (9, 16, 17, 30, 31) is connected via at least one connecting element (10, 20, 21) to the receptacle plate (6, 33, 34).

9. Arrangement (1, 2, 3, 4) according to any one of the preceding claims,
**characterized in that**
the substructure (40, 41, 42, 43) has a flatly formed base element (11), which is connected to the printed circuit board (45), in particular adhesively bonded or solder bonded.

10. Arrangement (1, 2, 3, 4) according to any one of the preceding claims,
**characterized in that**
the substructure (40, 41, 42, 43) has at least one meandering spring element (35, 36), wherein the receptacle plate (6, 33, 34) is connected by means of the spring element (35, 36) at least indirectly to the printed circuit board (45).

11. Arrangement (1, 2, 3, 4) according to any one of the preceding claims,
**characterized in that**
the substructure (40, 41, 42, 43) has at least one S-shaped spring element (35, 36), wherein the receptacle plate (6, 33, 34) is connected to the printed circuit board (45) at least indirectly via the spring element (35, 36) .

## Revendications

1. Sous-structure oscillante constituée de matière plastique (40, 41, 42, 43) qui est réalisée de manière à être disposée entre au moins un composant électronique (5, 25) et un circuit imprimé (45), et qui comporte une embase (6, 33, 34) destinée à recevoir le composant (5, 26) et est réalisé de manière à découpler le composant (5, 26) d'un bruit structurel produit par le circuit imprimé (45) sur la sous-structure (40, 41, 42, 43), dans lequel la sous-structure (40, 41, 42, 43) est réalisée sous la forme d'une structure MID (Molded-Interconnect-Device) spatiale, et comporte au moins une ligne de connexion électrique formée par une couche électriquement conductrice, qui est réalisée de manière à relier une borne électrique (22) du composant (5, 26) à une borne (24) du circuit imprimé (45), dans lequel la sous-structure (40, 41, 42, 43) comporte au moins une jambe de support (7, 8, 19, 32) qui est réalisée de manière à ce qu'elle soit reliée au circuit imprimé (45) dans la région d'une extrémité de la jambe de support (7, 8, 18, 19, 32) et est reliée au moins indirectement à l'embase (6, 33, 34), **caractérisée en ce qu'**un ressort de torsion est formé au moyen de la jambe de support (7, 8, 18, 19, 32) de manière à ce que le composant (5, 26) puisse effectuer un mouvement de rotation (13) en association avec l'embase (6, 33, 34).

2. Système (1, 2, 3, 4) comprenant un circuit imprimé (45) et un composant électronique (5, 26) découplé des vibrations, dans lequel le système (1, 2, 3, 4) comporte une sous-structure (40, 41, 42, 43) apte à vibrer selon la revendication 1, qui est reliée au circuit imprimé (45) sur une zone de surface du circuit imprimé (45), et qui comporte au moins une embase (6, 33, 34) destinée à recevoir le composant (5, 26) et est adaptée pour découpler le composant (5, 26) d'un bruit structurel agissant sur la sous-structure (40, 41, 42, 43), dans lequel l'embase (6) est reliée au composant (5, 26) et la sous-structure (40, 41, 42, 43) est formée de matière plastique, dans lequel le composant, notamment au moins une borne électrique (22) du composant (5, 26), est relié au circuit imprimé (45) au moyen d'au moins une ligne de connexion électrique (24, 25, 39, 54) formée par une couche électriquement conductrice, dans lequel la sous-structure (40, 41, 42, 43) est réalisée sous la forme d'une structure de type MID spatiale qui comporte l'au moins une ligne de connexion électrique (23, 25, 39, 54), dans lequel la sous-structure (40, 41, 42, 43) comporte au moins une jambe de support (7, 8, 18, 19, 32) s'étendant transversalement à une extension plane du circuit imprimé (45), notamment à un plan du circuit imprimé, qui est reliée au circuit imprimé (45) dans la région d'une extrémité de la jambe de support (7, 8, 18, 19, 32) et est reliée au moins indirectement à l'embase (6, 33, 34), dans lequel un ressort de torsion est formé au moyen de la jambe de support (7, 8, 18, 19, 32) de manière à ce que le composant (5, 26) puisse réaliser un mouvement de rotation (13) en association avec l'embase (6, 33, 34).

3. Système (1, 2, 3, 4) selon la revendication 2, **caractérisé en ce que** la sous-structure (40, 41, 42, 43) est réalisée de manière à découpler le composant (5, 26) d'un bruit structurel produit par le circuit imprimé (45) sur la sous-structure (40, 41, 42, 43) pour des fréquences supérieures à 500 Hz.

4. Système (1, 2, 3, 4) selon la revendication 2 ou 3, **caractérisé en ce que** la sous-structure (40, 41, 42, 43) comporte au moins un bras oscillant (9, 16, 17, 30, 31) qui est formé sur la jambe de support, qui s'étend transversalement à la jambe de support (7, 8, 18, 19, 32) et qui est relié au moins indirectement à l'embase (6, 33, 34).

5. Système (1, 2, 3, 4) selon l'une quelconque des revendications précédentes, **caractérisé en ce que** le bras oscillant (9, 16, 17, 30, 31) est relié à l'embase (6, 33, 34) au moyen d'un élément de liaison (10, 20, 21) qui relie ladite partie d'extrémité du bras oscillant (9, 16, 17, 30, 31) à l'embase (6, 33, 34).

6. Système (1, 2, 3, 4) selon l'une quelconque des revendications précédentes, **caractérisé en ce que** la sous-structure (40, 41, 42, 43) comporte au moins deux jambes de support (7, 8, 18, 19, 32) qui sont respectivement reliées à des parties d'extrémité mutuellement opposées d'un bras oscillant (9, 16, 17, 30, 31) par une partie d'extrémité opposée au circuit imprimé (45).

7. Système (1, 2, 3, 4) selon l'une quelconque des revendications précédentes, **caractérisé en ce que** la sous-structure (40, 41, 42, 43) comporte au moins deux bras oscillants (9, 16, 17, 30, 31) reliés l'un à l'autre, qui s'étendent respectivement parallèlement au plan du circuit imprimé et qui se croisent mutuellement.

8. Système (1, 2, 3, 4) selon la revendication 7, **caractérisé en ce que** l'un des bras oscillants (9, 16, 17, 30, 31) est relié par l'intermédiaire d'au moins une jambe de support (7, 8, 18, 19, 32) au circuit imprimé (45) et **en ce que** l'autre bras oscillant (9, 16, 17, 30, 31) est relié par l'intermédiaire d'au moins un élément de liaison (10, 20, 21) à l'embase (6, 33, 34).

9. Système (1, 2, 3, 4) selon l'une quelconque des revendications précédentes, **caractérisé en ce que** la structure (40, 41, 42, 43) comporte un élément formant pied (11) réalisé de manière plane, qui est relié au circuit imprimé (45), notamment par collage ou soudage.

10. Système (1, 2, 3, 4) selon l'une quelconque des revendications précédentes, **caractérisé en ce que** la sous-structure (40, 41, 42, 43) comporte au moins un élément à ressort sinueux (30, 35), dans lequel l'embase (6, 33, 34) est reliée au moins indirectement au circuit imprimé (45) au moyen de l'élément à ressort (35, 36) .

11. Système (1, 2, 3, 4) selon l'une quelconque des revendications précédentes, **caractérisé en ce que** la sous-structure (40, 41, 42, 43) comporte au moins un élément à ressort en forme de S (35, 36), dans lequel l'embase (6, 33, 34) est reliée au circuit imprimé (45) au moins indirectement par l'intermédiaire de l'élément à ressort (35, 36).
